# EUROPEAN PATENT SPECIFICATION

(11) **EP 3 794 643 B1**
(45) Date of publication and mention of the grant of the patent: **22.06.2022**
(21) Application number: 18726412.2
(22) Date of filing: 16.05.2018
(51) Int. Cl.: H01L 27/146

(54) **INTEGRATION OF A SHORT-WAVE INFRARED DETECTOR WITH CMOS COMPATIBLE SUBSTRATES**
INTEGRATION EINES KURZWELLIGEN INFRAROTDETEKTORS MIT CMOS-KOMPATIBLEN SUBSTRATEN
INTÉGRATION D'UN DÉTECTEUR INFRAROUGE À ONDES COURTES AVEC DES SUBSTRATS COMPATIBLES CMOS

(43) Date of publication of application: 24.03.2021
(73) Proprietor: IRIS Industries SA, 2024 Saint-Aubin-Sauges (CH)
(72) Inventor: FONTCUBERTA MORRAL, Anna, 1025 ST-Suplice (CH); CHUNG, Mintae, 1024 Ecublens (CH)
(74) Representative: Bovard SA Neuchâtel
(86) International application number: PCT/EP2018/062763
(87) International publication number: WO 2019/219189

(56) References cited:
- EP-A2- 2 017 893
- WO-A1-2018/042242
- CN-B- 102 280 456
- Amir Sammak ET AL: "CMOS-Compatible PureGaB Ge-on-Si APD Pixel Arrays", IEEE Transactions on Electron Devices, 1 January 2016 (2016-01-01), pages 92-99, XP055545691, New York DOI: 10.1109/TED.2015.2457241 Retrieved from the Internet: URL:http://www.imagesensors.org/Past%20Wor kshops/2009%20Workshop/2009%20Papers/053_p aper_ackland_noblepeak_swir.pdf

## Description

### Technical Field

The invention relates to the manufacturing of electromagnetic radiation detector arrays for intensity detection and imaging comprising Complementary Metal Oxide Semiconductor (CMOS) circuits and absorption materials, both sensitive to high temperature. More precisely the invention relates to short-wave infrared (SWIR) detector arrays, to optical systems comprising such arrays and to methods for forming such detector arrays and also to applications thereof.

### State of the art

Intensity and imaging detectors, equally named electromagnetic radiation photodiodes respectively Focal Plane Arrays (FPAs), are designed to convert the optical generation of electron-hole pairs released by impacting photons into electrical signals, further processed by a readout electronics and represented as an image on a computer screen. In addition to their high spatial and temporal resolution, these detectors also offer spectral resolution, since the energy of each incident photon is proportional to the number of generated electron-hole pairs and thus measurable by pulse height analysis.

Intensity detector arrays and FPAs, employing direct conversion by means of semiconductor absorbers, can currently be implemented in different ways. They can first be achieved by various material depositions. Polycrystalline or amorphous materials may directly be deposited on the readout electronics made from thin film transistors, whereas single crystals - that have better transport properties - could eventually be epitaxial grown on CMOS processed readout wafers, provided specific metallization schemes will allow for high process temperatures. To the current state of knowledge, this option couldn't be realized so far.

In a second perspective, intensity detector arrays FPAs may be integrated by various bonding processes. According to the most common one, the absorber is bonded by bump-bonding that allows for the use of any suitable semiconductor material from which large crystals may be grown, such as Si, Ge or GaAs. While with this technique it is a great challenge to push the pixel size below 50 µm, bump bonding is replaced by fusion bonding, including bonding with a patterned surface such as semiconducting pads surrounded by oxide. Both ways lead to complex structures that prevent a widespread use of the technology. By another bonding technique yet, the absorber layer and the CMOS layer are monolithically integrated by covalent bonding and subsequent annealing steps. Whereas the pixel size may be reduced by this method, according to our information, an efficient electrically conductive photodiode structure couldn't be demonstrated till now.

In a third perspective, intensity detector arrays and FPAs may be achieved by different absorber materials that are either application or integration specific, depending on their sensitivity, absorption or manufacturability, among others. Si-based detectors can eventually be manufactured without the use of a bonding process as a high-resistivity absorber layer may be epitaxially grown directly on the CMOS Si substrate. The readout electronics is then CMOS processed in this epitaxial layer and the substrate subsequently removed [Mattiazzo, 2013]. While these detectors may be used for ionizing radiation in high-energy physics, detection in the short-wave infrared (SWIR) spectrum is not possible with Si-based absorbers. Wavelengths detection between 1.00 and 1.55 µm usually requires indium-gallium-arsenide (InGaAs) absorption materials, whereas recent studies have demonstrated that GeSn-type alloys are better candidates with a higher cutoff wavelength and a better sensitivity. Although the GeSn growth process itself can be performed at low temperature - between 300°C and 330°C - its direct growth on Si is not reliable enough because of lattices mismatch and difference in the dilatation coefficients so that the integration process requires a buffer layer. Unfortunately, as known in the art [Yeh, 2014; Aubin, 2017; Zheng 2016], this can only be obtained at high annealing temperatures.

Thus, there is a need for a cost-effective fabrication of 3D integrated SWIR intensity detector arrays and FPA's allowing for layer deposition at temperatures compatible with CMOS substrates and other sensitive materials of the device, such as the conversion layer itself.

Document WO 2018/042242 shows a prior-art method of fabricating a SWIR detector array.

### Summary of the invention

The invention relates to a method of fabricating an intensity detector array, in particular a short-wave infrared focal plane array (SWIR FPA), comprising a temperature sensitive conversion layer temperature sensitive a CMOS wafer, and a p-n junction in order to allow for an efficient charge collection between both layers. It is understood that the detector array has basically a p-i-n diode structure, further described as an avalanche photodiode (APD) structure including a lightly p-doped i-region. The SWIR detector array is realized by a method of fabrication comprising the deposition of a buffer layer onto the CMOS processed wafer and applying energy onto it, comprising the step of using annealing at very short light pulses duration, before providing the conversion layer on top of the buffer layer.

It is yet a further object to provide a SWIR detector array suitable for single-photon detection and, therefore, energy-resolved SWIR detection and imaging, in which case the detector is called a focal plane array (FPA).

It is yet another object to provide a SWIR detector array which is fabricated at temperatures compatible with the CMOS substrates and other sensitive materials of the device, such as the conversion layer itself.

More precisely, the invention is achieved by a method of fabrication of a short-wave infrared detector array comprising a silicon readout wafer having a deposition surface and comprising a CMOS readout layer. The short-wave infrared detector array comprises a slightly doped buffer layer situated on said deposition surface and comprises a short-wave infrared light absorption layer, comprising Ge and Sn, situated on said doped buffer layer.

The method of the invention comprises the steps (A-D) of:
A. fabricating a readout wafer having a deposition surface, and comprising a silicon based CMOS readout layer and a p-n junction ;
B. providing on said deposition surface a slightly doped buffer layer comprising at least Ge and having an interface layer in contact with said deposition surface, said slightly doped buffer layer comprising, to its side away from said readout wafer, an oxide-free buffer layer surface;
C. sending light pulses, provided by a light source situated to the side of said slightly doped buffer layer opposite to said readout wafer, so as to crystallize said interface layer by the annealing effect of heat provided by the absorption of said light pulses by said interface layer, and so that a crystallized interface layer is provided and so that the temperature of the CMOS readout layer remains lower than 350°C during said annealing process;
D. depositing on said slightly doped buffer layer, at temperatures lower than 350°C, said absorption layer.

In an embodiment said absorption layer consists in a Ge₁₋ₓSnₓ alloy.

In an embodiment said absorption layer has a Sn content x between 0.05 ≤ x ≤ 0.25.

In an embodiment said absorption layer consists in a SiₓGe_{1-x-z}Sn_{z} alloy.

In an embodiment said absorption layer has a Si content x between 0 ≤ x ≤ 0.2.

In embodiment said absorption layer has a Sn content z between 0.05 ≤ z ≤ 0.15.

In an embodiment said absorption layer comprises an i-type Ge₁₋ₓSnₓ layer, in contact with said slightly doped buffer layer.

In an embodiment said i-type Ge₁₋ₓSnₓ layer has a thickness between 250nm and 5µm, preferably between 250 µm and 3 µm.

In an advantageous variant said absorption layer comprises, between said slightly doped buffer layer and said i-type Ge₁₋ₓSnₓ layer, a p+-type doped Ge₁₋ₓSnₓ layer having a doping concentration between 10¹⁹ to 5×10²⁰ cm⁻³.

In an embodiment said absorption layer comprises an i-type SiₓGe_{1-x-z}Sn_{z} layer, in contact with said slightly doped buffer layer.

The thickness of said absorption layer in all the embodiments of the invention is between 2 nm and 5 µm.

In an embodiment the absorption layer is realized by an epitaxial lift-off process.

In an embodiment said slightly doped buffer layer is a p-type doped Ge layer having a doping concentration between 10¹⁴ to 10¹⁵ cm⁻³.

In an embodiment said slightly doped buffer layer is realized by a technology including wafer-bonding and a layer splitting process.

In an embodiment said slightly doped buffer layer is realized by an epitaxial lift-off transfer process.

In an embodiment said slightly buffer layer is a p-type doped Ge₁₋ₓSnₓ layer having a doping concentration between 10¹⁴ to 10¹⁵ cm⁻³.

In an embodiment said p-type doped Ge₁₋ₓSnₓ buffer layer is realized by a technology including wafer-bonding and a layer splitting process.

In an embodiment said buffer layer is realized by a technology including wafer-bonding and an etch back and/or polishing process.

In an embodiment said slightly doped buffer layer is realized by an epitaxial lift-off transfer process.

The thickness of said slightly doped buffer layer in all the embodiments of the invention is between 5 nm and 3 µm.

In an embodiment said slightly doped buffer layer is etched after step B or after step C so as to provide an etched area of said slightly doped buffer layer.

In an advantageous variant said slightly doped buffer layer is at least partially covered after step B or after step C so as to provide a selectively covered area of said slightly doped buffer layer.

In an embodiment said etched area is covered by materials selected from: SiOₓ, SiN, Al₂O₃.

In an embodiment said selectively covered area is covered by materials selected from: SiOₓ, SiN, Al₂O₃.

In an embodiment the annealing temperature of said interface layer during the annealing process step C is higher than 650°C and lower than 750°C.

In an embodiment said light source provides light having a wavelength that is comprised between 300 nm and 900 nm.

In an embodiment the light is provided by a pulsed light source providing light pulses having a pulse duration of said light pulses lower than 1 ms, preferably lower than 100 ns.

In an embodiment the light source comprises at least one laser.

In an embodiment the light source comprises at least one pulsed lamp.

### Brief description of the drawings

Further details of the invention will appear more clearly upon reading the following description in reference to the appended figures:
- Figure 1 illustrates a cross-section of an hybrid detector array of prior art having an absorber layer and a readout layer connected by bump-bonding;

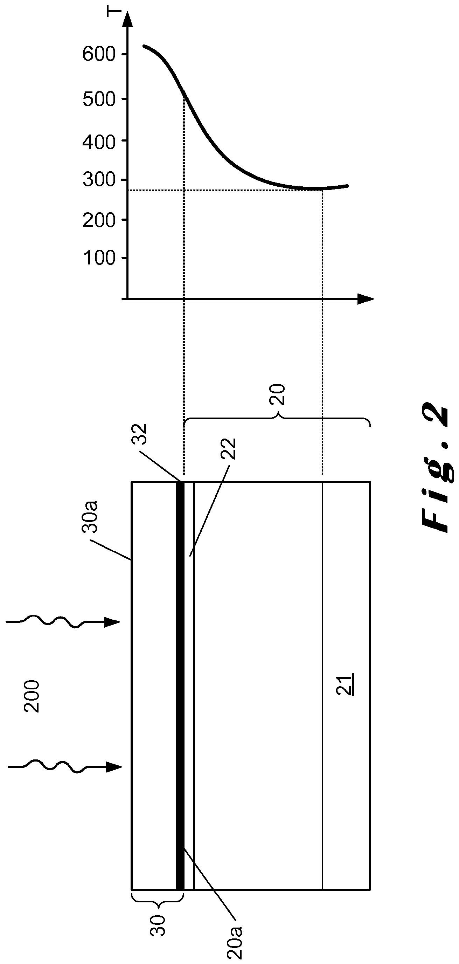

- Figure 2 illustrates the temperature profile, during the annealing process step of an interface layer of a slightly doped buffer layer, across a cross-section of a CMOS processed readout wafer with, on top of it, said slightly doped buffer layer;
- Figure 3 illustrates a preferred embodiment of the SWIR detector of the invention comprising a readout wafer comprising a p-i-n diode structure, a slightly doped buffer layer and an SWIR absorption layer;
- Figure 4 illustrated the electric field across an embodiment of the SWIR detector in operation;
- Figures 5 illustrates a cross section of an embodiment of the SWIR detector of the invention in operation, the electric field across the SWIR detector and the avalanche region provided by the application of that electric field;
- Figure 6 illustrated an embodiment of the SWIR detector of the invention comprising an intrinsic layer between the slightly doped buffer layer and a doped absorber layer;
- Figure 7 illustrates an etched area in the slightly doped buffer layer of the SWIR detector;
- Figure 8 illustrates a detection system comprising a fiber array and a linear SWIR detector array comprising two charge collecting areas;
- Figure 9 illustrates a detector part of an optical detection system comprising an optical fiber array and a SWIR detector array of the invention comprising an array charge collecting areas facing the output cores of the optical fibers of the array;
- Figure 10 illustrates the image detector portion of an optical imaging system configured to transmit light intensities or an image transmitted by the bundle of fibers of the optical imaging system to the charge collecting array of the SWIR detector of said optical imaging system.

### Detailed description and embodiments of the invention

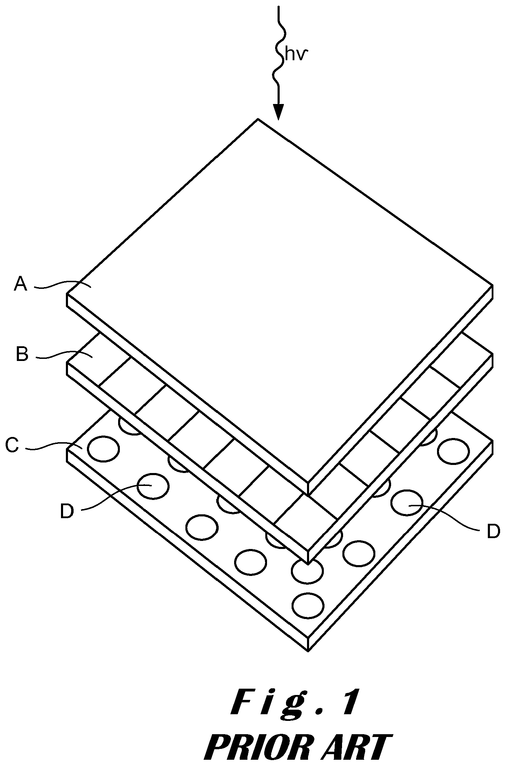

Fig. 1 illustrates a SWIR detector array 1 of prior art. As described in the prior art such a detector array comprises typically a microlens array (A) and an absorber sheet typically made of InGaAs (B), as well as a readout circuit realized on a separate layer or wafer. The stack comprising the optical layer (A) and the absorber layer (B) is electrically and mechanically connected to the CMOS layer (C) by an array of bumps (D).

The hybrid assembly of prior art infrared detector arrays, as illustrated in Fig.1, requires a complex and delicate alignment process and does not allow to provide large, cheap, reliable and high efficient SWIR detector arrays. It is the aim of this invention to provide simple structures and methods for the fabrication of sensitive SWIR FPA's.

Compared to infrared detectors of prior art, the device of the invention provides a highly efficient monolithic SWIR detector array 1 comprising a simplified 3D integrated structure having a small thickness, a reduced weight and lower power requirements. The SWIR detector array 1 of the invention is also called a focal plane array (FPA) hereafter. The device of the invention allows to provide very sensitive and large area monolithic FPAs able to cover efficiently the whole SWIR spectrum at room-temperature or eventually Peltier-cooled operation. Said SWIR spectrum is defined by a wavelengths range between 1.0 µm and 3.0 µm.

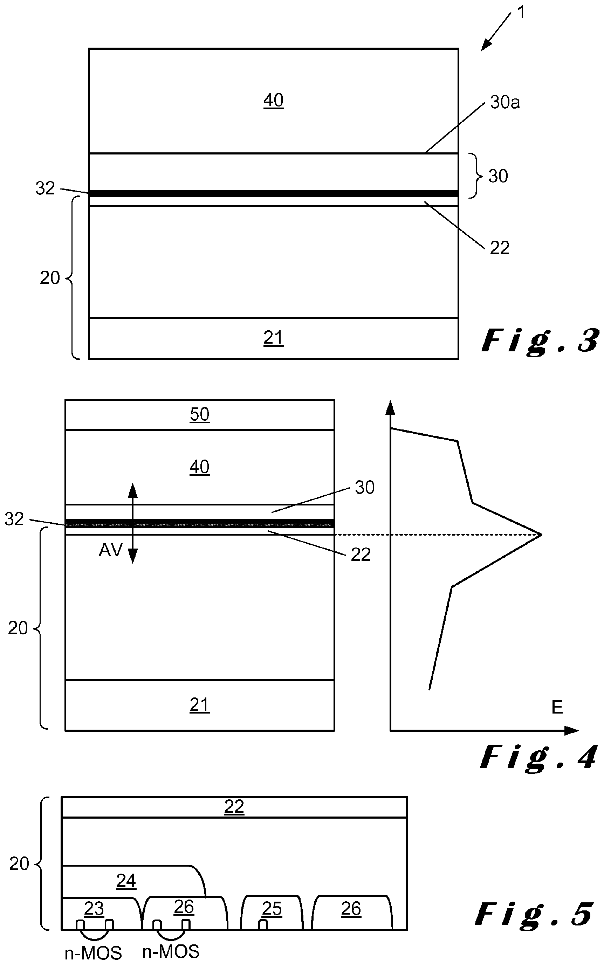

The SWIR detector array 1 of the invention, illustrated in Fig. 3, comprises at least:
- a SWIR light conversion layer 40, also defined as an absorber or absorption layer;
- a readout wafer 20 configured to collect, when the detector 1 is in operation , electrical charges provided by the conversion of electromagnetic waves in electrons and holes, the electromagnetic waves having a wavelength comprised between 1.0 µm and 3.0 µm.The readout wafer 20 has a deposition surface 20a;
- a slightly doped buffer layer 30 comprising a crystalline interface layer 32 that is in contact with said deposition surface 20a. Said crystalline interface layer 32 is a thin layer made of the same chemical composition as the slightly doped buffer layer 30 of which it is part, and is obtained by an annealing process during the manufacturing of the SWIR detector array 1 as further described in the section related to the process of manufacturing.

The SWIR detector array 1 of the invention may be configured to be suited for intensity measurements or as an imaging array in which case the detector array is called a Focal Plane Array as it is intended to be placed in the focal plane of an optical system. The SWIR detector array 1 comprises also an electrical contact layer 50 and a back contact configured to apply an electrical potential across the layers of the detector array 1. The electrical contact layer 50 may be a metallic layer, a transparent conducting layer or may be a doped layer such as a highly p or n-doped layer. In an embodiment said readout wafer 20 is a p-doped or n-doped wafer, but not necessarily so. It is understood that the readout wafer of the detector 1 of the invention may be configured in different ways but comprises always at least one electrical charge collecting area. In a preferred embodiment the readout wafer comprises an array of electrical charge collecting structures. The electrical charge collecting structures are preferably doped regions. The array of electrical charge collecting structures may be a 2D array, for example an array comprising 50 x 50 electrical charge collecting areas. In a variant, the array of charge collectors array may be a 1D array, comprising at least two charge collecting areas, which can be particularly useful in intensity detection applications comprising waveguides as described further.

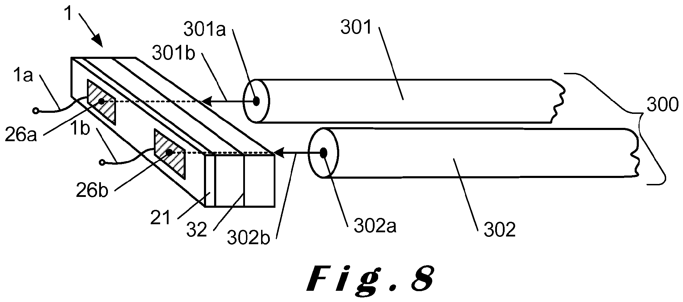

In a variant the, 1D or 2D SWIR detector array 1 may be made of an assembly of SWIR detectors 1 of the invention, comprising each a low number of electrical charge collecting areas, for example 10 electrical charge collecting areas per detector array 1. In a particular case wherein the spacing of the electrical charge areas may be relatively high, for example greater than 100 µm as illustrated in Fig. 8, the detector array 1 may comprise widely spaced charge collecting areas. In the case of imaging applications the detector array 1 is a FPA comprising densely packed charge collecting areas, as illustrated in Fig. 5 illustrating a single pixel of a FPA.

Fig. 4 illustrates the electrical field across an embodiment of the SWIR detector array 1 in operation. In operation, the electrical potential drop across the detector array 1 produces an electrical field E, illustrated in the graph of Fig. 4. Fig. 4 illustrates also an avalanche region (AV) provided by an electrical field E applied across the detector array 1. The extent of the avalanche region (AV) across the SWIR detector 1 in operation and depends on the particular configuration of the SWIR detector 1 and is therefore shown as an arrow (AV).

In a typical realization, the readout electronics is preferably processed in an epitaxial Si layer with a thickness of about 10 - 30 µm and a resistivity above about 500 Qcm or preferably about 1 - 2 kΩcm or more preferably 2 - 5 kΩ2cm or even above 5 kΩcm, for example 5 - 50 kΩcm, the resistivity being due to a low doping level in between about 10¹¹ to 10¹³ cm⁻³ of a first conduction type (for example n-conduction induced by n-doping). For ease of detector manufacturing, silicon-on-insulator (SOI) wafers may be used for the CMOS processing of the readout electronics. The thickness and the material used for the absorption layer strongly depends on the energy of the electromagnetic radiation to be detected.

An exemplary cross section of an embodiment of the readout layer 20, comprising a p-n diode layer 22, is illustrated in Fig. 5. As illustrated in the cross section of Fig. 5, a silicon layer 20 may comprise n+ charge collectors 24. In a preferred embodiment said absorption layer 40 is a lightly p-doped layer. In operation, each photon incident on the absorption layer 40 creates an electron-hole pair in the absorber 40. The hole is collected at the incident light side and the electron, created by the absorption of a photon, drifts to the avalanche region AV (Fig. 4) situated to the side of the p-n junction and is accelerated to sufficient energy to initiate a chain of impact ionization events, creating offspring electron-hole pairs and leading to internal gain. In the Geiger mode, known to the person skilled in the art, in which single photon can initiate an avalanche that is self-sustaining, carrier generation predominates over extraction leading to exponential growth of the current. In this mode the detector array has to be electrically reset by reducing the bias to below breakdown long enough to terminate the avalanche, a process known as quenching. Thus, when a reverse bias is applied to the back contact of the detector, the space charge layer expands from the p-n junction 22, as illustrated in figure 4, into the readout wafer 20, into said slight doped buffer layer 30 and as well as in the, preferable p-conducting, absorption layer 40. Figure 4 illustrates also the electric field E across the detector when a reverse bias is applied to a back contact of the detector array 1.

By construction, the SWIR detector array 1, such as a FPA of the invention provides single-photon detection. It is therefore suitable for energy discrimination, whereby the energy of photons incident on the absorber can be measured by employing the pulse height analysis of the electrical pulses processed by the readout electronics.

In an embodiment said buffer layer 30 consists of a slightly doped Ge layer and is preferably a p-type doped Ge layer having a doping concentration between 10¹⁴ to 10¹⁵ cm⁻³.

In an embodiment said slightly doped buffer layer 30 is made of Ge₁₋ₓSnₓ and has a Sn content x between 0.00 ≤ x ≤ 0.03, and is preferably a p-type doped Ge₁₋ₓSnₓ layer having a doping concentration between 10¹⁴ to 10¹⁵ cm⁻³.

As further described, said slightly doped buffer layer 30 may be advantageously be realized by an epitaxial lift-off transfer process.

In an embodiment said buffer layer (30 is realized by a technology including wafer-bonding and an etch back and/or a polishing process.

In an advantageous embodiment said absorption layer 40 consists in a Ge₁₋ₓSnₓ alloy. Said absorption layer 40 has preferably a Sn content x between 0.05 ≤ x ≤ 0.25.

In an embodiment said absorption layer 40 consists in a SiₓGe_{1-x-z}Sn_{z} alloy and has preferably a Si content x between 0 ≤ x ≤ 0.2.

In an embodiment of the absorption layer 40 consisting in a SiₓGe_{1-x-z}Sn_{z} alloy said absorption layer 40 has a Sn content z between 0.05 ≤ z ≤ 0.15.

In an advantageous embodiment said absorption layer 40 comprises an i-type Ge₁₋ₓSnₓ layer 42 being in contact with said slightly doped buffer layer 30. This layer can absorb up to 100% of the incident light with a photon wavelength greater than 1.4 µm, depending on the thickness.

Said i-type Ge₁₋ₓSnₓ layer may have a thickness between 250 nm and 5 µm, preferably between 250 nm and 3 µm.

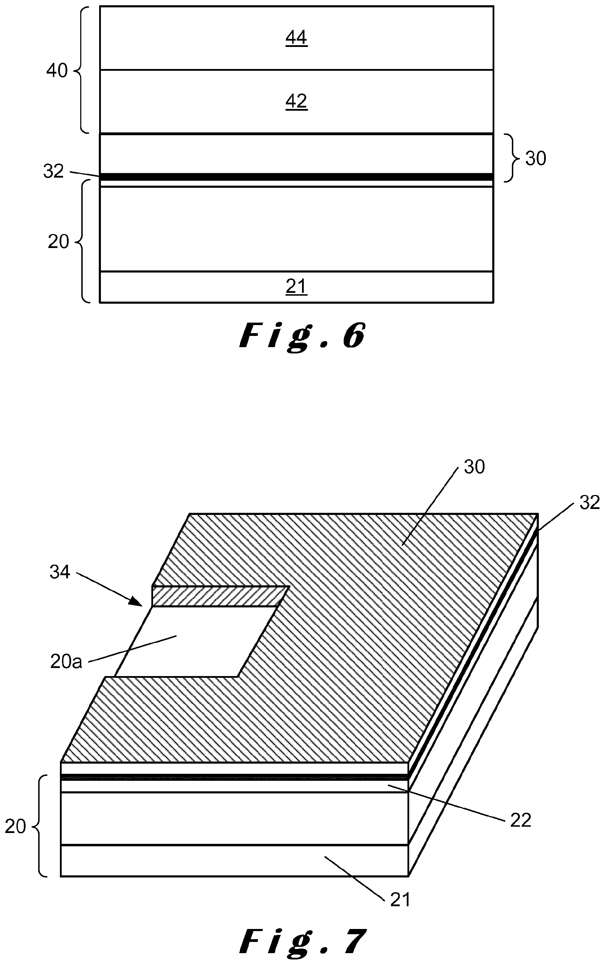

In a variant of execution, illustrated in figure 6, said absorption layer 40 comprises, between said slightly doped buffer layer 30 and said i-type Ge₁₋ₓSnₓ layer 42, a p⁺-type doped Ge₁₋ₓSnₓ layer 44 having a doping concentration between 10¹⁹ to 5 ×10²⁰ cm⁻³.

In an embodiment said absorption layer 40 comprises an i-type SiₓGe_{1-x-z}Sn_{z} layer, in contact with said slightly doped buffer layer 30.

In a variant of execution, similar to the arrangement of the embodiment of figure 6, said absorption layer 40 comprises, between said slightly doped buffer layer 30 and said i-type SiₓGe_{1-x-z}Sn_{z} layer, a p+-type doped Ge₁₋ₓSnₓ layer having a doping concentration between 10¹⁹ to 5x1020 cm⁻³.

In all embodiments the thickness of the absorption layer 40 is between 2 nm and 5 µm.In a variant, the thickness of the absorption layer 40 is between 1nm and 1000µm.

In variants, as illustrated in Fig. 7, an etched area 34 may be provided in the buffer layer 30. This etched area 34 extends across the whole thickness of the buffer layer 30 and may serve to deposit other materials, different to the buffer material, directly on said deposition surface 20a. These added other materials my serve to avoid the growth of absorption alloys such as Ge₁₋ₓSnₓ and SiₓGe_{1-x-z}Sn_{z} over predetermined areas.

In an embodiment said etched area 34 may be covered by materials selected from: SiOₓ wherein 1.9<x<2.0, SiN, HfO, Al₂O₃. Said coverage is not limited to these materials.

Also, a portion of the buffer layer 30 may also comprise a selectively covered area that is covered by materials selected from: SiOₓ wherein 1.9 < x < 2.0, SiN, HfO, Al₂O₃. These added other materials my serve to avoid the growth of absorption alloys such as Ge₁₋ₓSnₓ and SiₓGe_{1-x-z}Sn_{z} on the whole extension of the buffer layer.

In an embodiment at least a portion of said etched area 34 and a portion of said buffer layer 30 may be covered by materials selected from: SiOₓ wherein 1.9 < x < 2.0, SiN, HfO, Al₂O₃. In a variant said etched area 34 and a portion of said buffer layer 30 are covered by different materials.

It is understood that further layers than the ones described before may be added to the SWIR detector array, either between said readout wafer 20 and the buffer layer 30 as between the buffer layer 30 and the absorption layer 40.

For example, an optical layer having optical focusing properties may be arranged between said absorption layer 40 and said buffer layer. For example, at least one side of said absorption layer 30 may be corrugated and have for example the shape of an array of microlenses so as to provide a focused light beam on a focal plane coincident with said interfacial layer 32. In the variant in which the absorption layer 30 is structured or corrugated to the side of said readout wafer 20, the interface layer 32 will have the same structured or corrugated shape as the structured or corrugated surface of said absorption layer 30.

In an embodiment an antireflection coating is added in order to maximize the amount of light coupled into the device/absorbing layer.

Depending on the desired electrical performances of the detector array 1 the composition and thickness of any of the layers of the detector 1 may be configured so as to shape a predetermined electrical field profile across the avalanche region (AV) of the detector 1. Shaping electrical field profiles is well known in the art and is not further commented here.

An exemplary execution of a small part of the cross-section of the thinned CMOS processed readout wafer 20 of a SWIR detector array 1 comprises a p-n junction 22 is now described and illustrated in Fig. 5. The width of the section illustrated in figure 5, defined in the plane of the readout wafer 21, corresponds to slightly more than a single pixel size of the detector array 1, and may range for example from 5 -20 µm,20 - 50 µm,50 -100 µm, depending on the CMOS process used. In this configuration, n-wells 25 serve as charge collectors, collecting electrons coming from electron-hole pairs which are generated by incident photons and separated in the electric field of the p-n junction formed by a preferably lightly n-doped Si CMOS processes readout wafer 20 and a lightly p-doped layer. The distance between adjacent n-wells 25 defines the pixel size of the detector array. In the embodiment of figure 5, n-MOS transistors of the pixel electronics of the readout are situated in p-wells 26 and n-wells 23, respectively. A deep p-well 24 arranged on said p-wells 26 and n-wells 23, has the purpose of avoiding electron collection by n-wells 23 in addition to charge collecting by n-well 25. In an aspect of the embodiment part of the pixel electronics may be located in n-well 25. In this configuration the p-n junction 22 is inside the readout wafer, preferably at the interface between a lightly p-doped layer and a lightly n-doped main part of SOI wafer 20. The lightly n-doped main part of SOI wafer 20 comprises preferably a thin, lightly p-doped Si layer with a highly resistive n-doped layer on top, hosting the CMOS processed readout. The lightly p-doped layer may have a thickness of about 1- 2 µm, 2 - 5 µm or even in the range from 5 - 50 µm or 50 - 100 µm. Substrate and buried oxide of the SOI wafer are thereby removed prior to further processing of the device.

It has to be noticed that in variants the detector array 1 may comprise electrical connections such as electrical wires 1a, 1b, connected to said charge collecting areas as illustrated in Fig.8.

In an example, illustrated in Fig. 8, a SWIR detector array 1 may be configured as a linear array of SWIR detectors having said charge collecting arrays 26a, 26b arranged linearly. This can be useful for example to detect the intensity of light provided by the output surfaces of a linear array 300 of fibers. In the same way, a SWIR detector array 1 may be configured so that each charge collecting area 26 faces the output surface of a fiber of a fiber bundle 300, as illustrated in Fig. 8. The fiber bundle 300 may be arranged according to a circular arrangement or according to another arrangement such as a square, hexagonal, or rectangular arrangement. The advantage of realizing a detector array 1 having charge collecting areas 26 having the same geometric distribution as the output surfaces of the fibers of a fiber bundle 300, allows to avoid using imaging optics between the output surfaces of the waveguides and the charge collectors. It is understood that, rather than fiber optics, flat optical waveguides may be used of which each output surface faces a charge collecting area of the detector array 1. It is also understood that in all embodiments of the detector array 1, at least one electrical wire may be connected to the CMOS layer 21, and more precisely to at least one charge collecting area as illustrated in the example of Fig.8.

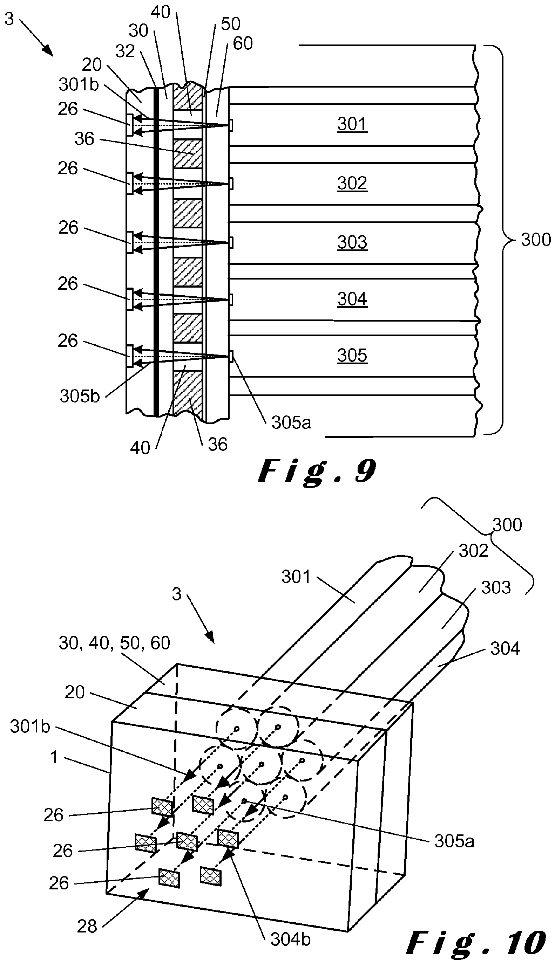

The invention is also realized by a SWIR detection system 3 comprising an array 300 of waveguides 301-305 and a SWIR detector array 1 as described, and of which a portion only is illustrated in Fig.10. The waveguides may be fiber optics or planar waveguides. In variants the waveguides may be mono-mode waveguides or multimode waveguides. In a variant said optical fibers are arranged in specific 2 dimensions, such as a hexagonal arrangement of fiber optics as shown in Fig.10, or in a linear array as illustrated in Fig. 8. Other geometrical configurations of the waveguides are also possible. In a variant a stack of flat substrates comprising each at least one waveguide may be arranged in said SWIR detection system 3.

In embodiments the cores 301a-305a of the waveguides 301-305 are facing a charge collector as illustrated in Fig. 8-10. Realizing a SWIR detection system 3 wherein the charge collectors have the same geometrical distribution than the one of the waveguide array 300, as illustrated in Figs. 9 and 10 is particularly interesting to provide an SWIR imaging system wherein an image is transferred from one end of a waveguide array 300 , such as a fiber bundle, to another end of the array. Butt-coupling a bundle of waveguides such as a fiber bundle is known to the skilled person and is not further described herein. For example, as shown in Fig.9, optical fibers may be arranged at a predetermined distance relative to the entry face of the detector, which may be for example the contact layer 50. The gap layer 60 separating the entry face of the detector 1 and the outcoupling surfaces of the waveguides may be air or may be a SWIR transparent material, such as a glue layer or any other material transparent in the SWIR wavelength range. A gap layer may also comprise focusing lenses, such as an array of microlenses. Also, the skilled person knows how to incouple light, in various ways, into a bundle of waveguides or fibers, therefore the incoupling portion of the imaging system 3, situated opposite to the outcoupling surfaces 301a-305a is not illustrated in the figures.

In an exemplary realization the number of waveguides may be more than 100, more than 1000 or more than 10000. The distance between the waveguides or fibers may vary according to the application. In an exemplary configuration the optical fibers are arranged in contact and according to a hexagonal distribution such as illustrated in Fig.10 which illustrates only 7 fibers of a closed packed optical fiber bundle.

In a variant, the detector array 1 of a SWIR detection system 3, particularly an imaging SWIR detection system 3, may comprise covered portions 36 on said buffer layer 30. As explained further, said covered portions 36 may be realized only on etched areas 34 of the buffer layer 30 and/or may partially cover a portion of the buffer layer 30. Such covered portions 36 may be implemented in configurations such as the one illustrated in Fig.9 so as to reduce light cross coupling effects, which may be produced by light emitted by a waveguide and transmitted to a charge collecting area that does not face that waveguide.

By monolithically integrating a waveguide array 300, such as a fiber bundle, to a SWIR detector array, cheap and robust SWIR flexible imaging systems may be provided.

The assembly of fiber bundles or waveguides with detectors and detector arrays are known to the skilled person and are not described further here.

The invention is also achieved by a method of fabrication of a short-wave infrared detector array 1 comprising a silicon readout wafer 20 having a deposition surface 20a and comprising a CMOS readout layer. The short-wave infrared detector array 1 comprises a slightly doped buffer layer 30 situated on said deposition surface 20a and comprises a short-wave infrared light absorption layer 40, comprising Ge and Sn, situated on said doped buffer layer 30. The deposition of a buffer layer 30 between the Si CMOS processed readout wafer and the absorption layer is an essential step to overcome the differences of lattices and dilatation coefficients between Si and materials such as alloys of the type Ge₁₋ₓSnₓ or SiₓGe_{1-x-z}Sn_{z}.

More precisely the method of the invention comprises the steps (A-D) of:
A. fabricating a readout wafer 20 having a deposition surface 20a, and comprising a silicon based CMOS readout layer 21 and a p-n junction 22;
B. providing on said deposition surface 20a a slightly doped buffer layer 30 comprising at least Ge and having an interface layer 32 in contact with said deposition surface 20a, said slightly doped buffer layer 30 comprising, to its side away from said readout wafer 20, an oxide-free buffer layer surface 30a ;
C. sending light pulses 200, provided by a light source situated to the side of said slightly doped buffer layer opposite to said readout wafer, so as to crystallize said interface layer by the annealing effect of heat provided by the absorption of said light pulses by said interface layer 32, and so that a crystallized interface layer 32 is provided and so that the temperature of the CMOS readout layer 21 remains lower than 350°C during said annealing process;
D. depositing on said slightly doped buffer layer 30, at temperatures lower than 350°C, said absorption layer 40.

In an embodiment said absorption layer 40 consists in a Ge₁₋ₓSnₓ alloy.

In an embodiment said absorption layer 40 has a Sn content x between 0.05 ≤ x ≤ 0.25.

In an embodiment said absorption layer 40 consists in a SiₓGe_{1-x-z}Sn_{z} alloy.

In an embodiment said absorption layer 40 has a Si content x between 0 ≤ x ≤ 0.2.

In an embodiment said absorption layer 40 has a Sn content z between 0.05 ≤ z ≤ 0.15.

In an embodiment said absorption layer 40 comprises an i-type Ge₁₋ₓSnₓ layer, in contact with said slightly doped buffer layer 30.

In an embodiment said i-type Ge₁₋ₓSnₓ layer has a thickness between 250 nm and 5 µm,preferably between 250 nm and 3 µm.

In an advantageous variant said absorption layer comprises, between said slightly doped buffer layer and said i-type Ge₁₋ₓSnₓ layer, a p⁺-type doped Ge₁₋ₓSnₓ layer having a doping concentration between 10¹⁹ to 5×10²⁰ cm⁻³.

In an embodiment, said absorption layer comprises an i-type SiₓGe_{1-x-z}Sn_{z} layer, in contact with said slightly doped buffer layer 30.

The thickness of said absorption layer 40 in all the embodiments of the invention is between 2 nm and 5 µm.

In an embodiment the absorption layer 40 is realized by an epitaxial lift-off process. In such an epitaxial lift-off process a thin film of germanium is realized on a layer of a material that can be selectively etched, for example GaAs or AIGaAs or a combination of both. This layer is then bonded on a CMOS substrate. Subsequently the GaAs or AIGaAs (or combination) is selectively etched so that the Ge is freed from the original substrate and transferred to the CMOS substrate.

In a variant said absorption layer may be realized by successively deposited layers of Ge and Sn. These successively deposited layers may have different thicknesses.

In an embodiment said slightly doped buffer layer 30 is a p-type doped Ge layer having a doping concentration between 10¹⁴ to 10¹⁵ cm⁻³.

In an embodiment said slightly doped buffer layer 30 is realized by a technology including wafer-bonding and a layer splitting process. A typical example of such a process is the know Smartcut process which is a Trademark as described in: http://www.soitec.com/fr/produits/smart-cut.

In such a process Ge deposited on a substrate, and is implanted with hydrogen ions (H⁺) with a dose comprised between 5 x 10¹⁶ and 5 x 10¹⁷ cm⁻² and an energy comprised between 1keV and 100keV. It is then bonded to the CMOS substrate and flash annealed in order to separate the Ge layer from its substrate. The final structure comprises the CMOS substrate comprising a thin Ge layer that has split off from the original implanted Ge substrate. In a variant, the implantation comprises a co-implantation with He⁺ up to 50% of the total implanted dose of Ge and He.

In an embodiment said slightly doped buffer layer 30 is realized by an epitaxial lift-off transfer process similar to the epitaxial lift-off transfer process of said absorption process as described above.

In an embodiment said slightly buffer layer 30 is a p-type doped Ge₁₋ₓSnₓ layer having a doping concentration between 10¹⁴ to 10¹⁵ cm⁻³.

In an embodiment said p-type doped Ge₁₋ₓSnₓ buffer layer is realized also by said technology including wafer-bonding and a layer splitting process. Similar as described before, a typical example of such a process is the known Smartcut process (Trademark of Soitec).

In an embodiment said slightly doped buffer layer is realized by an epitaxial lift-off transfer process. In such an epitaxial lift-off transfer process a thin film of Ge₁₋ₓSnₓ is realized on a substrate made of a material that can be selectively etched, for example GaAs or AIGaAs or a combination of both. The substrate is then bonded on the CMOS substrate. Subsequently the GaAs or AIGaAs (or combination) is selectively etched so that the Ge₁₋ₓSnₓ layer is freed from the original substrate and transferred to the CMOS substrate.

The thickness of said slightly doped buffer layer in all the embodiments of the invention is between 5 nm and 3 µm.

In an embodiment said slightly doped buffer layer is etched after step B or after step C so as to provide an etched area of said slightly doped buffer layer.

In an advantageous variant said slightly doped buffer layer is at least partially covered after step B or after step C so as to provide a selectively covered area of said slightly doped buffer layer.

In an embodiment said etched area 34 is preferably covered by materials selected from: SiOₓ wherein 1.9 < x < 2.0, SiN, HfO, Al₂O₃. Said etched area 34 may also be covered by other materials that avoid the growth of a SWIR absorbing layer on the covered area.

In an embodiment said selectively covered area is covered by materials selected from: SiOₓ, SiN, Al₂O₃.

In an embodiment the annealing temperature of said interface layer during the annealing process step C is higher than 650°C and lower than 750°C.

In an embodiment said light source provides light having a wavelength that is comprised between 300 nm and 900 nm.

In an embodiment the light is provided by a pulsed light source providing light pulses having a pulse duration of said light pulses lower than 1 ms, preferably lower than 100 ns.

In an embodiment the light source comprises at least one laser.

In an embodiment the light source comprises at least one pulsed lamp.

The invention is also achieved by a detector array realized according to the above described fabrication method.

The deposition process may be achieved by different ways that determine the performance of the detector as well as the industrial scalability of its manufacturing.

In variants the optical layer 500 comprises an array of refractive microlens, or an array of diffractive microlenses, or an array of aspheric shaped microlenses, or an array of microprisms or an array of plasmonic planar metalenses allowing for multi/hyper-spectral imaging and analysis.

### Exemplary Applications

The SWIR detector array, such as a FPA, may be used in various types of applications such as ground, airborne and space technology for intelligence, surveillance, military, security or encryption systems. It may also be used for spectroscopy, machine vision or non-invasive clinical investigations such as optical coherence tomography. More precisely, the SWIR detector array can be integrated into and used in methods of the following fields of applications as described below.

### LIDAR

System-level benefits of large FPAs are related to providing a large instantaneous field of view and a fully electronic selection by reading out a region of interest (FOV). Large FPAs allow monitoring of large areas and enable key applications, such as high-resolution, wide-area airborne persistent surveillance. The detector larger format with smaller pixel size helps to solve the unmanned - aerial or terrestrial - vehicle (UV) automated "sense and avoid" problem. By using an array of detectors in a FPA, the mechanical scanning needed in single-detector systems can be avoided and because a photon-counting FPA has the ability to digitally time stamp individual photon arrivals it is an enabler for highly sensitive light detection and ranging ("LIDAR") imaging systems. In a LIDAR system the scene is illuminated by a short laser pulse, and imaged onto the FPA, where each single-photon avalanche diode measures photon arrival time, and therefore depth to the corresponding point in the scene whereas the image is built up by combining multiple frames.

### Multi/hyper-spectral LIDAR imaging

Most minerals contain distinct absorption features in the SWIR, making this region of the spectrum the best candidate for spectroscopic analysis in many applications. Hydroxyl bearing minerals, sulfates, and carbonate materials produced naturally on earth - or directly related to human activities such as the burning of fossil fuels and the deforestation - are easily identified through SWIR spectroscopy. Multi/ hyper-spectral LIDAR imaging can thus provide a powerful tool for mapping, archaeology, earth science, glaciology, agricultural assessment and disaster response.

### Waveguide based SWIR imaging

There are a wide range of applications wherein a direct image may not be formed on a detector array. For example this is the case wherein difficult accessible places have to be imaged. The use of imaging systems using a bundle of fibers or flexible flat waveguides may be mandatory. Applications may be found for example in the field of industrial endoscopes for example to inspect the inside of tubings.

### References

### Publications

1. Aubin J. et al., "Impact of thickness on the structural properties of high tin content GeSn layers", Journal of Crystal Growth, 473, 20-27, 2017
2. Lee J. et al., "Crystallization and Characterization of GeSn Deposited on Si with Ge Buffer Layer by Low-temperature Sputter Epitaxy, Journal of Semiconductor Technology and Science, Vol. 16, No 6, December 2016
3. Mattiazzo S. et al., "LePIX: first results from a novel monolithic sensor", Nucl. Instr. Meth. Phys. Res. A 718, 288-291, 2013
4. Yeh W. et al., "Sputter Epitaxial Growth of Flat Germanium Film with Low Threading-Dislocation Density on Silicon (001)", ECS journal of Solid State Science and Technology, 3 (10) Q195-Q199, 1 Aug 2014
5. Zahler J.M. et al " Role of hydrogen in hydrogen-induced layer exfoliation of germanium" Phys. Rev. B 75, 035309, 2007
6. Zheng J. et al., "GeSn p-i-n photodetectors with GeSn layer grown by magnetron sputtering epitaxy", Appl. Phys. Letters 108, 033503, 20 Jan 2016

## Claims

1. A method of fabrication of a short-wave infrared detector array (1) comprising a silicon readout wafer (20), having a deposition surface (20a), comprising a CMOS readout layer (21) comprising at least two charge collecting structures, said short-wave infrared detector array (1) comprising a slightly doped buffer layer (30) situated on said deposition surface (20a) and a short-wave infrared light absorption layer (40), comprising Ge and Sn, situated on said doped buffer layer (30),
the method comprising the steps (A-D) of:
A. fabricating a readout wafer (20) having a deposition surface (20a), and comprising a silicon based CMOS readout layer (21) and a p-n junction (22);
B. providing on said deposition surface (20a) a slightly doped buffer layer (30) comprising at least Ge and having an interface layer (32) in contact with said deposition surface (20a), said slightly doped buffer layer (30) comprising to its side away from said readout wafer (20), an oxide-free buffer layer surface (30a);
C. sending light pulses (200), provided by a light source situated to the side of said slightly doped buffer layer (30) opposite to said readout wafer (20), so as to crystallize said interface layer (32) by the annealing effect of heat provided by the absorption of said light pulses (200) by said interface layer (32), and so that temperature of the CMOS readout layer (21) remains lower than 350°C during the annealing process;
D. depositing on said slightly doped buffer layer (30), at temperatures lower than 350°C, said absorption layer (40).

2. The method according to claim 1 wherein said absorption layer (40) comprises an i-type Ge₁₋ₓSnₓ layer, in contact with said slightly doped buffer layer (30).

3. The method according to claim 2 wherein said i-type Ge₁₋ₓSnₓ layer has a thickness between 250nm and 5µm, preferably between 250nm and 3µm.

4. The method according to claims 2 or 3 wherein said absorption layer (40) comprises, between said slightly doped buffer layer (30) and said i-type Ge₁₋ₓSnₓ layer, a p+-type doped Ge₁₋ₓSnₓ layer having a doping concentration between 10¹⁹ to 5×10²⁰ cm⁻³.

5. The method according to any one of claims 1 to 4 wherein the absorption layer (40) is realized by an epitaxial lift-off process.

6. The method according to any one of claims 1 to 5 wherein said slightly doped buffer layer (30) is a p-type doped Ge layer having a doping concentration between 10¹⁴ to 10¹⁵ cm⁻³.

7. The method according to any one of claims 1 to 6 wherein said slightly doped buffer layer (30) is realized by a technology including wafer-bonding and a layer splitting process.

8. The method according to any one of claims 1 to 6 wherein said slightly doped buffer layer (30) is realized by a technology including wafer-bonding and an etch back and/or polishing process.

9. The method according to any one of claims 1 to 6 wherein said slightly doped buffer layer (30) is realized by an epitaxial lift-off transfer process.

10. The method according to any one of claims 1 to 9 wherein said slightly doped buffer layer (30) is a p-type doped Ge₁₋ₓSnₓ layer having a doping concentration between 10¹⁴ to 1015 cm⁻³.

11. The method according to claim 10 wherein said p-type doped Ge₁₋ₓSnₓ buffer layer (30) is realized by a technology including wafer-bonding and a layer splitting process.

12. The method according to any one of claims 1 to 11 wherein the thickness of said slightly doped buffer layer (30) is between 5 nm and 3 µm.

13. The method according to any one of claims 1 to 12 wherein said slightly doped buffer layer (30) is etched after step B or after step C so as to provide an etched area (34) of the buffer layer (30).

14. The method according to any one of claims 1 to 13 wherein the light is provided by a pulsed light source providing light pulses (200) having a pulse duration of said light pulses (200) lower than 1 ms, preferably lower than 100 ns.

## Patentansprüche

1. Verfahren zur Herstellung einer Kurzwellen-Infrarot-Detektoranordnung (1), die einen Silicium-Auslesewafer (20) umfasst, der eine Abscheideoberfläche (20a) aufweist, die eine CMOS-Ausleseschicht (21) umfasst, die mindestens zwei Ladungssammlungsstrukturen umfasst, wobei die Kurzwellen-Infrarot-Detektoranordnung (1) eine schwach dotierte Pufferschicht (30), die sich auf der Abscheideoberfläche (20a) befindet, und eine Ge und Sn umfassende Kurzwellen-Infrarotlicht-Absorptionsschicht (40) umfasst, die sich auf der dotierten Pufferschicht (30) befindet,
wobei das Verfahren die folgenden Schritte (A-D) umfasst:
A. Herstellen eines Auslesewafers (20), der eine Abscheideoberfläche (20a) aufweist und eine siliciumbasierte CMOS-Ausleseschicht (21) und einen p-n-Übergang (22) umfasst;
B. Bereitstellen auf der Abscheideoberfläche (20a) einer schwach dotierten Pufferschicht (30), die mindestens Ge umfasst und eine Grenzschicht (32) aufweist, die in Kontakt mit der Abscheideoberfläche (20a) ist, wobei die schwach dotierte Pufferschicht (30) auf ihrer vom Auslesewafer (20) abgewandten Seite eine oxidfreie Pufferschichtoberfläche (30a) umfasst;
C. Senden von Lichtimpulsen (200), die von einer Lichtquelle bereitgestellt werden, die zu der Seite der schwach dotierten Pufferschicht (30) gerichtet ist, die dem Auslesewafer (20) entgegengesetzt ist, um die Grenzschicht (32) durch den Ausheilungseffekt von Wärme, die durch die Absorption der Lichtimpulse (200) durch die Grenzschicht (32) bereitgestellt wird, zu kristallisieren, und derart, dass die Temperatur der CMOS-Ausleseschicht (21) während des Ausheilungsprozesses unter 350°C bleibt;
D. Abscheiden der Absorptionsschicht (40) auf der schwach dotierten Pufferschicht (30) bei Temperaturen unter 350°C.

2. Verfahren nach Anspruch 1, wobei die Absorptionsschicht (40) eine Ge₁₋ₓSnₓ-Schicht vom Typ i umfasst, die in Kontakt mit der schwach dotierten Pufferschicht (30) ist.

3. Verfahren nach Anspruch 2, wobei die Ge₁₋ₓSnₓ-Schicht vom Typ i eine Dicke zwischen 250 nm und 5 µm, vorzugsweise zwischen 250 nm und 3 µm, aufweist.

4. Verfahren nach Anspruch 2 oder 3, wobei die Absorptionsschicht (40) zwischen der schwach dotierten Pufferschicht (30) und der Ge₁₋ₓSnₓ-Schicht vom Typ i eine p+-dotierte Ge₁₋ₓSnₓ-Schicht mit einer Dotierungskonzentration zwischen 10¹⁹ und 5×10²⁰ cm⁻³ umfasst.

5. Verfahren nach einem der Ansprüche 1 bis 4, wobei die Absorptionsschicht (40) mit einem epitaktischen Lift-off-Prozess ausgeführt wird.

6. Verfahren nach einem der Ansprüche 1 bis 5, wobei die schwach dotierte Pufferschicht (30) eine p-dotierte Ge-Schicht mit einer Dotierungskonzentration zwischen 10¹⁴ und 10¹⁵ cm⁻³ ist.

7. Verfahren nach einem der Ansprüche 1 bis 6, wobei die schwach dotierte Pufferschicht (30) mit einer Technologie ausgeführt wird, die Waferbonden und einen Schichtabspaltungsprozess umfasst.

8. Verfahren nach einem der Ansprüche 1 bis 6, wobei die schwach dotierte Pufferschicht (30) mit einer Technologie ausgeführt wird, die Waferbonden und einen Rückätz- und/oder Polierprozess umfasst.

9. Verfahren nach einem der Ansprüche 1 bis 6, wobei die schwach dotierte Pufferschicht (30) mit einem epitaktischen Lift-off-Transferprozess ausgeführt wird.

10. Verfahren nach einem der Ansprüche 1 bis 9, wobei die schwach dotierte Pufferschicht (30) eine p-dotierte Ge₁₋ₓSnₓ-Schicht mit einer Dotierungskonzentration zwischen 10¹⁴ und 10¹⁵ cm⁻³ ist.

11. Verfahren nach Anspruch 10, wobei die p-dotierte Ge₁₋ₓSnₓ-Pufferschicht (30) mit einer Technologie ausgeführt wird, die Waferbonden und einen Schichtabspaltungsprozess umfasst.

12. Verfahren nach einem der Ansprüche 1 bis 11, wobei die Dicke der schwach dotierten Pufferschicht (30) zwischen 5 nm und 3 µm beträgt.

13. Verfahren nach einem der Ansprüche 1 bis 12, wobei die schwach dotierte Pufferschicht (30) nach Schritt B oder nach Schritt C geätzt wird, um eine geätzte Fläche (34) der Pufferschicht (30) bereitzustellen.

14. Verfahren nach einem der Ansprüche 1 bis 13, wobei das Licht von einer gepulsten Lichtquelle bereitgestellt wird, die Lichtimpulse (200) bereitstellt, die eine Impulsdauer dieser Lichtimpulse (200) von weniger als 1 ms, vorzugsweise weniger als 100 ns, aufweisen.

## Revendications

1. Procédé de fabrication d'un réseau de détecteurs infrarouges à ondes courtes (1) comprenant une tranche de lecture à base de silicium (20), présentant une surface de dépôt (20a), comprenant une couche de CMOS de lecture (21) comprenant au moins deux structures de collecte de charge, ledit réseau de détecteurs infrarouges à ondes courtes (1) comprenant une couche tampon légèrement dopée (30) située sur ladite surface de dépôt (20a) et une couche d'absorption de lumière infrarouge à ondes courtes (40), comprenant du Ge et du Sn, située sur ladite couche tampon dopée (30),
le procédé comprenant les étapes (A-D) de :
A. fabrication d'une tranche de lecture (20) présentant une surface de dépôt (20a) et comprenant une couche de CMOS de lecture à base de silicium (21) et une jonction p-n (22) ;
B. disposition, sur ladite surface de dépôt (20a), d'une couche tampon légèrement dopée (30) comprenant au moins du Ge et présentant une couche d'interface (32) en contact avec ladite surface de dépôt (20a), ladite couche tampon légèrement dopée (30) comprenant sur son côté opposé à ladite tranche de lecture (20) une surface de couche tampon exempte d'oxyde (30a) ;
C. envoi d'impulsions lumineuses (200), fournies par une source de lumière située sur le côté de ladite couche tampon légèrement dopée (30) opposé à ladite tranche de lecture (20), de façon à cristalliser ladite couche d'interface (32) par l'effet de recuit de la chaleur fournie par l'absorption desdites impulsions lumineuses (200) par ladite couche d'interface (32) et de telle sorte que la température de la couche de CMOS de lecture (21) reste inférieure à 350 °C pendant le procédé de recuit ;
D. dépôt, sur ladite couche tampon légèrement dopée (30), à des températures inférieures à 350 °C, de ladite couche d'absorption (40).

2. Procédé selon la revendication 1, ladite couche d'absorption (40) comprenant une couche de Ge₁₋ₓSnₓ de type i, en contact avec ladite couche tampon légèrement dopée (30).

3. Procédé selon la revendication 2, ladite couche de Ge₁₋ₓSnₓ de type i présentant une épaisseur située entre 250 nm et 5 µm, préférablement entre 250 nm et 3 µm.

4. Procédé selon les revendications 2 ou 3, ladite couche d'absorption (40) comprenant, entre ladite couche tampon légèrement dopée (30) et ladite couche de Ge₁₋ₓSnₓ de type i, une couche de Ge₁₋ₓSnₓ dopée de type p+ présentant une concentration de dopage entre 10¹⁹ et 5×10²⁰ cm⁻³.

5. Procédé selon l'une quelconque des revendications 1 à 4, la couche d'absorption (40) étant réalisée par un procédé de retrait épitaxial.

6. Procédé selon l'une quelconque des revendications 1 à 5, ladite couche tampon légèrement dopée (30) étant une couche de Ge dopée de type p présentant une concentration de dopage entre 10¹⁴ et 10¹⁵ cm⁻³.

7. Procédé selon l'une quelconque des revendications 1 à 6, ladite couche tampon légèrement dopée (30) étant réalisée par une technologie comprenant une liaison de tranche et un procédé de séparation de couche.

8. Procédé selon l'une quelconque des revendications 1 à 6, ladite couche tampon légèrement dopée (30) étant réalisée par une technologie comprenant une liaison de tranche et un procédé de gravure en retrait et/ou de polissage.

9. Procédé selon l'une quelconque des revendications 1 à 6, ladite couche tampon légèrement dopée (30) étant réalisée par un procédé de transfert par retrait épitaxial.

10. Procédé selon l'une quelconque des revendications 1 à 9, ladite couche tampon légèrement dopée (30) étant une couche de Ge₁₋ₓSnₓ dopée de type p présentant une concentration de dopage entre 10¹⁴ et 10¹⁵ cm⁻³.

11. Procédé selon la revendication 10, ladite couche tampon de Ge₁₋ₓSnₓ dopée de type p (30) étant réalisée par une technologie comprenant une liaison de tranche et un procédé de séparation de couche.

12. Procédé selon l'une quelconque des revendications 1 à 11, l'épaisseur de ladite couche tampon légèrement dopée (30) étant située entre 5 nm et 3 µm.

13. Procédé selon l'une quelconque des revendications 1 à 12, ladite couche tampon légèrement dopée (30) étant gravée après l' étape B ou après l' étape C de façon à réaliser une zone gravée (34) de la couche tampon (30).

14. Procédé selon l'une quelconque des revendications 1 à 13, la lumière étant fournie par une source de lumière pulsée fournissant des impulsions lumineuses (200) présentant une durée d'impulsion desdites impulsions lumineuses (200) inférieure à 1 ms, préférablement inférieure à 100 ns.
